# EUROPEAN PATENT SPECIFICATION

(11) **EP 4 270 785 B1**
(45) Date of publication and mention of the grant of the patent: **28.10.2026**
(21) Application number: 22881221.0
(22) Date of filing: 13.09.2022
(51) Int. Cl.: H02J 7/80, H02J 1/02, H01M 10/42

(54) **BATTERY MANAGEMENT DEVICE COMPRISING NOISE REDUCTION CIRCUIT**
BATTERIEMANAGEMENTGERÄT MIT RAUSCHUNTERDRÜCKUNGSSCHALTUNG
DISPOSITIF DE GESTION DE BATTERIE COMPORTANT UN CIRCUIT DE RÉDUCTION DE BRUIT

(30) Priority: 15.10.2021 KR 20210137090
(43) Date of publication of application: 01.11.2023
(73) Proprietor: LG ENERGY SOLUTION, LTD., Seoul 07335 (KR)
(72) Inventor: KIM, Jaehwan, Daejeon 34122 (KR)
(74) Representative: Plasseraud IP
(86) International application number: PCT/KR2022/013613
(87) International publication number: WO 2023/063592

(56) References cited:
- WO-A1-2020/002672
- WO-A1-2021/111822
- KR-A- 20140 025 565
- KR-A- 20140 047 554
- KR-A- 20200 089 637
- KR-A- 20230 077 365
- KR-B1- 100 777 006
- KR-B1- 101 027 965

## Description

### [Technical Field]

The present invention relates to a noise reduction circuit and a battery management apparatus including the same, and more particularly, to a noise reduction circuit for providing a variable cutoff frequency through control of a capacitor capacity of an RC filter and a battery management apparatus including the noise reduction circuit.

### [Background Art]

Secondary batteries are batteries that can be recharged and reused repeatedly. Secondary batteries are typically manufactured as a battery module or a battery pack formed by connecting a plurality of battery cells in series according to an output capacity required by a device to be used as power supply sources for various devices. Such batteries are being used in various fields ranging from small high-tech electronic devices such as smart phones to electric bicycles, vacuum cleaners, electric vehicles (EVs, Light EVs), and energy storage systems (ESS).

A battery module or battery pack is a structure in which a plurality of battery cells are combined. When overvoltage, overcurrent, or overheating occurs in some battery cells, a problem occurs in safety and operating efficiency of the entire battery module or battery pack. Thus, a means for detecting these problems are essential. Accordingly, a battery module or battery pack is equipped with a battery management system (BMS) that measures a voltage value of each battery cell and monitors and controls a voltage state of the battery cells based on measured values.

Here, a process of converting an analog value measured through monitoring into a digital value, i.e., an Analog-to-Digital Converting (ADC) is required in order to detect states of battery cells and determine an abnormal situation. However, when frequencies to be blocked differ depending on an environment in which the device is installed and designing in consideration of frequency noise in various installation environments is needed, a problem occurs that accuracy of an ADC operation is reduced, and thus, an appropriate solution is required.

WO2021/111822 A1 relates to a battery monitoring device. WO2020/002672 A1 relates to an electrical system for a motor vehicle, KR 2023 0077365 relates to a circuit configured to provide a variable cutoff frequency.

### [Summary]

### [Technical Problem]

Embodiments of the present disclosure provide a noise reduction circuit.

Embodiments of the present disclosure also provide a battery management apparatus including the noise reduction circuit.

### [Technical Solution]

In order to achieve the objective of the present disclosure, a noise reduction circuit according to an example useful for understanding of the invention may comprise a first circuit including at least one resistance element and a first capacitor, and connected to an analog-to-digital converter; and a second circuit connected in parallel with the first capacitor and connected to the analog-to-digital converter through one or more input/output pins, wherein the second circuit is activated or deactivated according to control of the analog-to-digital converter, so that a noise cutoff frequency generated by the first circuit and the second circuit is adjusted.

The second circuit may include a second capacitor connected in parallel with the first capacitor; and a switch positioned between the second capacitor and a ground, wherein the second capacitor and the switch are connected to the analog-to-digital converter through the one or more input/output pins.

The one or more input/output pins may include: a first general-purpose input/output (GPIO) for connecting the analog-to-digital converter and the second capacitor; and a second GPIO for connecting the analog-to-digital converter and the switch.

A first noise cutoff frequency generated by the first circuit may differ from a second noise cutoff frequency generated by the first circuit and the second circuit.

A first resistance element among the at least one resistance element of the first circuit and the first capacitor may be connected to the analog-to-digital converter through the first GPIO.

Here, the switch may be a field effect transistor (FET) or a bipolar junction transistor (BJT).

According to an aspect of the present disclosure, a battery management apparatus according to claim 1 is provided.

The analog-to-digital converter may be included in a micro controller Unit (MCU) or in a battery monitoring integrated chip (BMIC).

### [Advantageous Effects]

According to embodiments of the present disclosure, it is possible to variably control a cut-off frequency of an RC filter according to an environment in which it is necessary to secure analog-to-digital converting (ADC) performance or an environment in which low-frequency noise reduction is required.

Accordingly, performance improvement and convenience increase can be expected in a battery management system (BMS) performing analog-to-digital converting.

### [Brief Description of the Drawings]

FIG. 1 shows a structure of a battery system to which the present invention may be applied.
FIG. 2 shows a noise reduction circuit applied to a conventional analog-to-digital converter.
FIG. 3 shows a noise reduction circuit and a battery management apparatus according to embodiments of the present invention.
FIGs. 4A and 4B are graphs illustrating examples of ADC sensing data values with noise reduced using an RC filter.

### [Detailed Description]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the scope of the claims. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

The terminology used herein is for the purpose of describing particular embodiments only and is not intended to be limiting of the invention. As used herein, the singular forms "a", "an" and "the" are intended to include the plural forms as well, unless the context clearly indicates otherwise. It will be further understood that the terms "comprises", "comprising,", "includes" and/or "including", when used herein, specify the presence of stated features, integers, steps, operations, elements, and/or components, but do not preclude the presence or addition of one or more other features, integers, steps, operations, elements, components, and/or groups thereof.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, exemplary embodiments of the present invention will be described in detail with reference to the accompanying drawings.

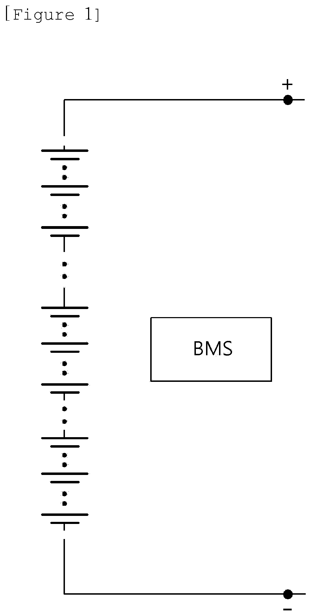

FIG. 1 shows a structure of a battery system to which the present invention may be applied.

In FIG. 1, a battery pack or battery module may include a plurality of battery cells connected in series. The battery pack or module may be connected to a load through a positive terminal and a negative terminal to perform charging or discharging.

A battery management system (BMS) 100 may be installed in a battery module or battery pack. The BMS may monitor a current, a voltage and a temperature of each battery pack to be managed, calculate a state of charge (SOC) of the battery based on monitoring results to control charging and discharging. Here, the State of Charge (SOC) refers to a current state of charge of a battery, represented in percent points [%], and the State of Health (SOH) may be a current condition of a battery compared to its ideal conditions, represented in percent points [%].

The BMS 100 may include various components such as a fuse, a current sensing element, a thermistor, a switch, and a balancer to perform such operations. In most cases, a micro controller unit (MCU) or a battery monitoring integrated chip (BMIC) for interworking and controlling these components is additionally included in the BMS. Here, the BMIC may be located inside the BMS and may be an integrated circuit (IC) type component that measures information such as voltage, temperature, and current of a battery cell/module.

Meanwhile, in order for the BMS to detect the state of the battery cell and determine an abnormal situation, an analog-to-digital converting (ADC) operation for converting an analog value measured through monitoring into a digital value is required.

In a conventional case, an ADC operation is performed by an MCU or a BMIC, which performs ADC conversion for voltage, current, and temperature values that are input through general-purpose input/output (GPIO) pins of the MCU or the BMIC. Here, an RC (Resistor-Capacitor) filter is used to reduce frequency noise of a voltage signal or a temperature signal input through the general-purpose input/output (GPIO) pins.

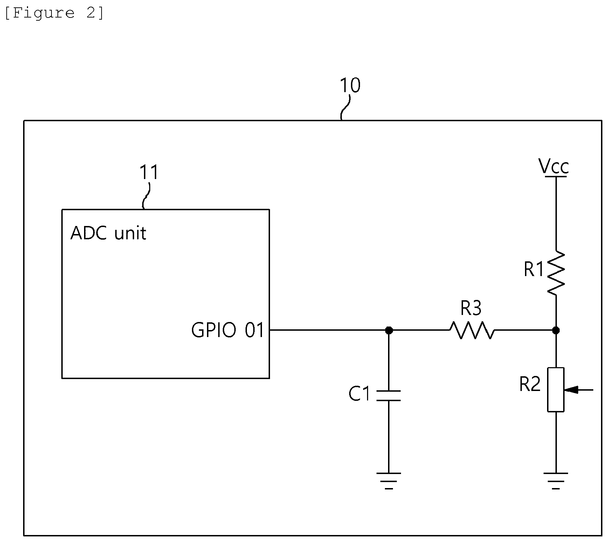

FIG. 2 shows a noise reduction circuit applied to a conventional analog-to-digital converter.

Referring to FIG. 2, the BMS 10 may include an ADC operation unit 11. The ADC operation unit 11 may be a BMIC or MCU, and may include a plurality of GPIO pins. In Figure 2, GPIO 01 pin is used for ADC operation. The ADC operation unit converts measured analog signals, such as cell voltages and resistance values, into digital values.

In the example of FIG. 2, a thermistor R2 is used as a battery cell-related monitoring target. A noise reduction circuit including a resistor and a capacitor is disposed between R2 (monitoring target) and GPIO 01 pin of the ADC operation unit 11.

The conventional noise reduction circuit shown in FIG. 2 includes one capacitor C1 and one or more resistors R3. More specifically, the noise reduction circuit may be configured to have resistor R1, resistor R3 and capacitor C1, wherein one side of resistor R1 is connected to a power supply (Vcc) and the other side of resistor R1 is connected to one side of resistor R2 (PTC or NTC element), wherein one side of resistor R3 is connected to a connection point of resistor R1 and resistor R2 and the other side of resistor R3 is connected to the GPIO pin, and wherein capacitor C1 is connected to the GPIO pin and the ground.

Here, the thermistor may be a positive temperature coefficient (PTC) thermistor or a negative temperature coefficient (NTC) thermistor.

A positive temperature coefficient (PTC) thermistor is a semiconductor device having a characteristic in which a resistance value changes according to temperature. As the temperature rises, the resistance value increases, and as the temperature decreases, the resistance value decreases. A negative temperature coefficient (NTC) thermistor also has a characteristic that its resistance value changes according to temperature, but, opposite to the PTC. The NTC thermistor has a characteristic that the resistance value decreases when the temperature rises and the resistance value increases when the temperature decreases.

In this conventional noise reduction circuit, a cutoff frequency using an RC (resistor-capacitor) circuit including C1 and R3 is applied. Here, the cutoff frequency may be determined according to Equation 1 below. [Equation 1] ${F}_{cutoff} = \frac{1}{2 {πR}_{3} {C}_{1}} .$

In Equation 1, F_{cutoff} represents a cutoff frequency, R3 represents a resistance value of resistor R3, and C1 represents a capacitance value of capacitor C1.

In this circuit, once the capacitor and the resistor selected according to determined capacitance and resistance values are mounted on a device, the capacitance of the capacitor cannot be changed thereafter. However, when the installation environment changes, the target noise to be reduced also changes accordingly. Somehow, desired noise reduction cannot be achieved since the cutoff frequency of the existing RC circuit cannot be changed.

As such, when applying an analog-to-digital converter within a BMS, a resistance and a capacitor capacity of the RC filter are selected in consideration of overall noise environment and ADC accuracy of the product. However, when a range of frequencies to be blocked varies depending on an installation environment and designing of an RC filter in consideration of frequency noise of all installation environments is needed, ADC accuracy is degraded, which makes the RC filter design difficult.

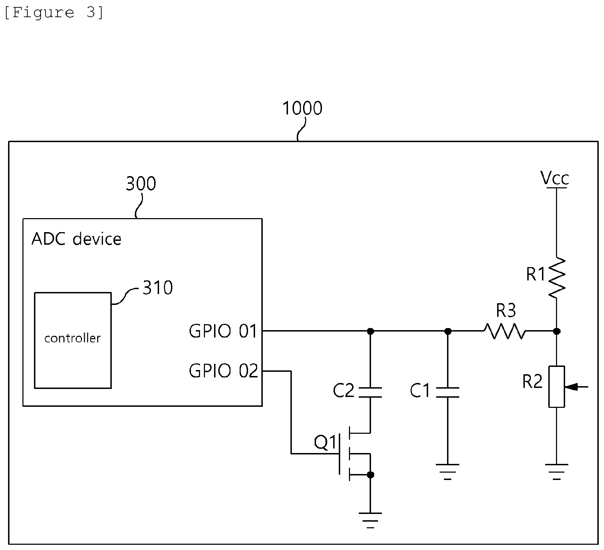

FIG. 3 shows a noise reduction circuit and a battery management apparatus according to embodiments of the present invention.

The noise reduction circuit according to embodiments of the present invention shown in FIG. 3 includes a first circuit including at least one resistance element and a first capacitor, and connected to an analog-to-digital converting device 300; and a second circuit connected in parallel with the first capacitor C1 and connected to the analog-to-digital converter through one or more input/output pins.

The first circuit may include one capacitor C1 and one or more resistors R3 in the same manner as a conventional noise cancelling circuit.

The second circuit includes a second capacitor (C2) connected in parallel with the first capacitor (C1) and a switch Q1 positioned between the second capacitor and the ground. Here, the second capacitor and the switch are connected to the analog-to-digital converting device 300 through one or more input/output pins.

Here, the switch Q1 may be implemented as a field effect transistor (FET) device or a bipolar junction transistor (BJT) device.

In addition, a battery management apparatus 1000 according to embodiments of the present invention comprises: an analog-to-digital converter including one or more input/output pins; a noise reduction circuit including a first circuit and a second circuit, the first circuit including at least one resistance element and a first capacitor and connected to the analog-to-digital converter, wherein the second circuit is connected in parallel with the first capacitor and connected to the analog-to-digital converter through the one or more input/output pins, and wherein the second circuit is activated or deactivated according to control of the analog-to-digital converter, so that a noise cutoff frequency generated by the first circuit and the second circuit is adjusted.

Here, the one or more input/output pins may include: a first general-purpose input/output (GPIO) for connecting the analog-to-digital converter and the second capacitor; and a second GPIO for connecting the analog-to-digital converter and the switch.

Referring to FIG. 3, the controller 310 in the analog-to-digital converting device determines a cutoff frequency according to a frequency noise of an environment in which the battery management device is located, and determine whether to activate the second circuit according to the determined cutoff frequency. In FIG. 3, the analog-to-digital converting device may be a micro controller unit (MCU) or a battery monitoring integrated chip (BMIC). The analog-to-digital converting device may also be included in a micro controller unit (MCU) or a battery monitoring integrated chip (BMIC).

Here, the controller may transmit an activation signal or a deactivation signal for the second circuit to a switch Q1 of the second circuit through the second GPIO (GPIO 2). The switch receiving the activation signal is turned on so that the second capacitor C2 is connected to the first GPIO and the ground, and thus, the first capacitor and the second capacitor are connected in parallel. On the other hand, the switch receiving the inactivation signal for the second circuit is turned off and the second capacitor becomes in an OPEN state so that only the signal from the first circuit including the first capacitor and the resistance element is input to the first GPIO.

The cutoff frequency when the controller 310 deactivates the second circuit may be determined by the first circuit, and the cutoff frequency may be determined as defined in Equation 1 above.

On the other hand, when the controller 310 activates the second circuit, the first capacitor C1 of the first circuit and the second capacitor C2 of the second circuit are arranged in parallel, and, the total capacitor capacity for this case can be represented as (C1 + C2).

Accordingly, the cutoff frequency generated by the first circuit and the second circuit may be determined according to equation 2 below. [Equation 2] ${F}_{cutoff} = \frac{1}{2 {πR}_{3} \left({C}_{1}+{C}_{2}\right)}$

In Equation 2, *F_{cutoff}* represents the cutoff frequency, R3 represents a resistance value of resistor R3, C1 represents a capacitance value of capacitor C1, and C2 represents a capacitance value of capacitor C2.

In summary, the cutoff frequency provided by the first circuit and the second circuit according to embodiments of the present invention may be controlled as one of the first cutoff frequency (Equation 1) and the second cutoff frequency (Equation 2). In other words, the first noise cutoff frequency and the second noise cutoff frequency may be set to different values.

Meanwhile, in the embodiment of FIG. 3, a case where a monitoring target is a thermistor (R2) has been described as an example, but a BMS monitoring target may also be a voltage sensor or a current sensor. In this case, the analog signal detected by a corresponding device may be a voltage value or a current value.

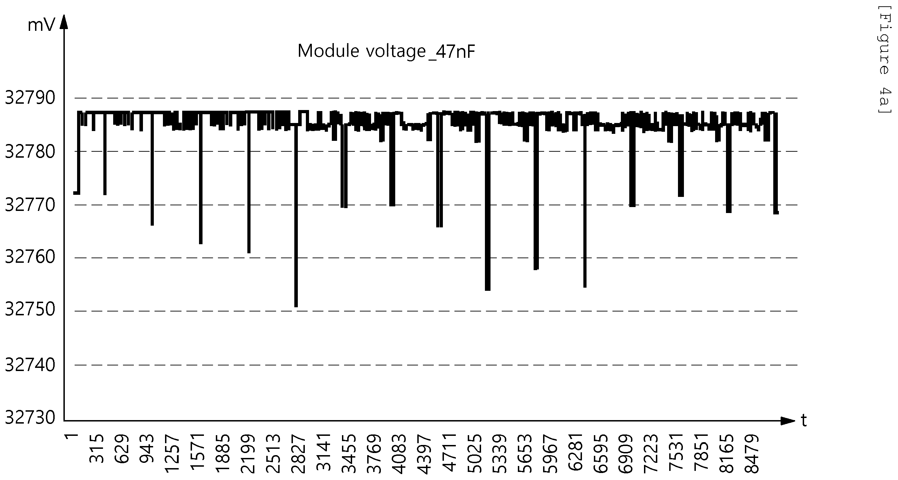

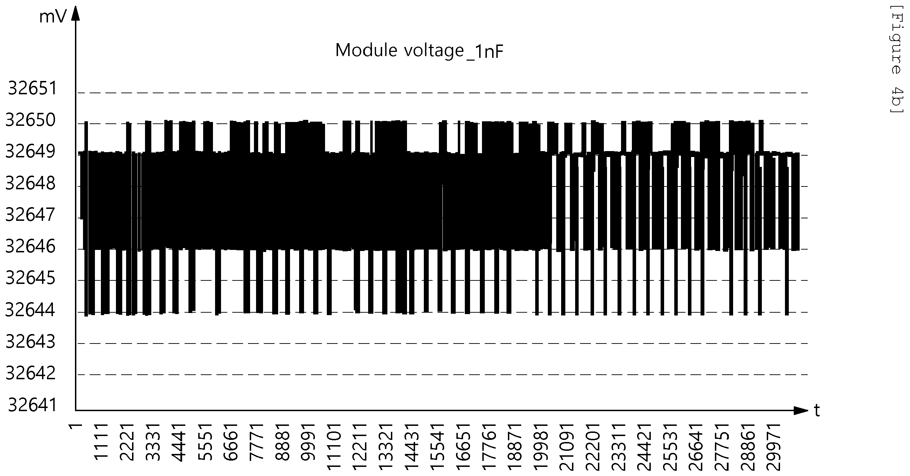

FIGs. 4A and 4B are graphs illustrating examples of ADC sensing data values with noise reduced using an RC filter.

Data sensed through the examples of FIGs. 4A and 4B are module voltages, the horizontal axis of the graph represents time (t), and the vertical axis represents a module voltage (mV). In the example of FIG. 4A, a capacitor having a capacity of 47nF was used for a RC filter, and in the example of FIG. 4B, a capacitor having a capacity of 1nF was used.

It can be understood from the graphs of FIGS. 4A and 4B that ADC performance may vary depending on a capacitance of an RC filter in the same circuit. For example, when a 47nF capacitor is used, the deviation of the calculated module voltage value (the difference between the maximum value and the minimum value) is 4mV, but when a 1nF capacitor is used, the deviation of the calculated module voltage value is 0.5mV. From this, it can be seen that the example of FIG. 4B is advantageous in terms of ADC performance.

On the other hand, in case of using a 1nF capacitor, the cutoff frequency is 47 times larger than that of a 47nF capacitor, and accordingly, it is difficult to block low-frequency noise.

Thus, the example of FIG. 4A using a capacitor of relatively high capacitance is advantageous for blocking low-frequency noise. Furthermore, the example of FIG. 4B using a capacitor of relatively low capacitance is advantageous in terms of ADC performance.

In summary, the capacitance of the capacitor can be differently applied by using a filter with a relatively low capacitance when it is necessary to secure ADC performance according to installation environments and end-user requirements and by using a filter with a relatively high capacitance when low-frequency noise reduction is particularly needed.

If these data are applied to the above-described embodiments of the present invention, a first circuit having a capacitor capacity of C1 may be applied in an environment requiring ADC performance, and a first circuit and a second circuit having a capacitor capacity of (C1 + C2) may be applied in an environment requiring low-frequency noise reduction. In other words, the cut-off frequency can be variably controlled through an RC filter circuit implementation that inactivates the second circuit when securing ADC performance is required and that activates the second circuit when reducing low-frequency noise is required.

The embodiments of the present disclosure may be implemented as program instructions executable by a variety of computers and recorded on a computer readable medium. The computer readable medium may include a program instruction, a data file, a data structure, or a combination thereof. The program instructions recorded on the computer readable medium may be designed and configured specifically for the present disclosure or can be publicly known and available to those who are skilled in the field of computer software.

Examples of the computer readable medium may include a hardware device such as ROM, RAM, and flash memory, which are specifically configured to store and execute the program instructions. Examples of the program instructions include machine codes made by, for example, a compiler, as well as high-level language codes executable by a computer, using an interpreter. The above exemplary hardware device can be configured to operate as at least one software module in order to perform the embodiments of the present disclosure, and vice versa.

## Claims

1. A battery management apparatus comprising:
an analog-to-digital converter (300) including one or more input/output pins (GPIO 01, GPIO 02); and
a noise reduction circuit including a first circuit and a second circuit, the first circuit including at least one resistance element and a first capacitor (C1), the second circuit including a second capacitor (C2) connected in series with a switch (Q1) positioned between the second capacitor (C2) and a ground, the series connected switch and second capacitor being connected in parallel with the first capacitor;
wherein the second capacitor (C2) and the switch (Q1) are connected to the analog-to-digital converter (300) through the one or more input/output pins;
wherein the analog-to-digital converter (300) further comprises a controller (310), **characterized in that** the controller (310) is configured to:
determine a cut-off frequency according to frequency noise of an environment in which the battery management device is located, and
determine whether to activate the second circuit, by activating the switch (Q1), according to the determined cut-off frequency, so that a noise cutoff frequency generated by the first circuit and the second circuit is adjusted.

2. The battery management apparatus of claim 1, wherein a first noise cutoff frequency generated by the first circuit differs from a second noise cutoff frequency generated by the first circuit and the second circuit.

3. The battery management apparatus of claim 1, wherein the one or more input/output pins include:
a first general-purpose input/output, GPIO, for connecting the analog-to-digital converter and the second capacitor; and
a second GPIO for connecting the analog-to-digital converter and the switch.

4. The battery management apparatus of claim 3, wherein a first resistance element among the at least one resistance element of the first circuit and the first capacitor are connected to the analog-to-digital converter through the first GPIO.

5. The battery management apparatus of claim 1, wherein the controller (310) is configured to transmit an activation signal or a deactivation signal for the second circuit to the switch (Q1) of the second circuit through the second GPIO.

6. The battery management apparatus of claim 1, wherein the analog-to-digital converter (300) is included in a micro controller Unit, MCU, or in a battery monitoring integrated chip, BMIC.

7. The battery management apparatus of claim 1, wherein the switch (Q1) is a field effect transistor, FET, or a bipolar junction transistor, BJT.

## Patentansprüche

1. Betteriemanagementvorichtung, umfassend:
einen Analog-Digital-Wandler (300), der einen oder mehrere Eingangs-/Ausgangsanschlüsse (GPIO 01, GPIO 02) enthält; und
eine Rauschunterdrückungsschaltung, die eine erste Schaltung und eine zweite Schaltung enthält,
wobei die erste Schaltung mindestens ein Widerstandselement und einen ersten Kondensator (C1) enthält,
wobei die zweite Schaltung einen zweiten Kondensator (C2) und einen Schalter (Q1) enthält, der zwischen dem zweiten Kondensator (C2) und einer Masse positioniert ist, wobei der in Reihe geschaltete Schalter und der zweite Kondensator parallel zum ersten Kondensator geschaltet sind;
wobei der zweite Kondensator (C2) und der Schalter (Q1) mit dem Analog-Digital-Wandler (300) über den einen oder die mehreren Eingangs-/Ausgangsanschlüsse verbunden sind;
wobei der Analog-Digital-Wandler (300) ferner eine Steuerung (310) umfasst,
**dadurch gekennzeichnet, dass** die Steuerung (310) konfiguriert ist zum:
Bestimmen einer Grenzfrequenz gemäß dem Frequenzrauschen einer Umgebung, in der sich die Batteriemanagementvorrichtung befindet, und
Bestimmen, ob die zweite Schaltung durch Aktivieren des Schalters (Q1) gemäß der bestimmten Grenzfrequenz zu aktivieren ist, sodass eine durch die erste Schaltung und die zweite Schaltung erzeugte Rauschgrenzfrequenz angepasst wird.

2. Batteriemanagementvorrichtung nach Anspruch 1, wobei sich eine erste durch die erste Schaltung erzeugte Rauschgrenzfrequenz von einer zweiten durch die erste Schaltung und die zweite Schaltung erzeugten Rauschgrenzfrequenz unterscheidet.

3. Batteriemanagementvorrichtung nach Anspruch 1, wobei der eine oder die mehreren Eingangs-/Ausgangsanschlüsse umfassen:
einen ersten universellen Eingang/Ausgang, GPIO, zum Verbinden des Analog-Digital-Wandlers und des zweiten Kondensators; und
einen zweiten GPIO zum Verbinden des Analog-Digital-Wandlers und des Schalters.

4. Batteriemanagementvorrichtung nach Anspruch 3, wobei ein erstes Widerstandselement unter dem mindestens einen Widerstandselement der ersten Schaltung und der erste Kondensator mit dem Analog-Digital-Wandler über den ersten GPIO verbunden sind.

5. Batteriemanagementvorrichtung nach Anspruch 1, wobei die Steuerung (310) konfiguriert ist, um ein Aktivierungssignal oder ein Deaktivierungssignal für die zweite Schaltung an den Schalter (Q1) der zweiten Schaltung über den zweiten GPIO zu übertragen.

6. Batteriemanagementvorrichtung nach Anspruch 1, wobei der Analog-Digital-Wandler (300) in einer Mikrocontrollereinheit, MCU, oder in einem integrierten Chip zur Batterieüberwachung, BMIC, enthalten ist.

7. Batteriemanagementvorrichtung nach Anspruch 1, wobei der Schalter (Q1) ein Feldeffekttransistor, FET, oder ein bipolarer Sperrschichttransistor, BJT, ist.

## Revendications

1. Appareil de gestion de batterie comprenant :
un convertisseur analogique-numérique (300) incluant une ou plusieurs broches d'entrée/sortie (GPIO 01, GPIO 02) ; et
un circuit de réduction de bruit incluant un premier circuit et un second circuit,
le premier circuit incluant au moins un élément de résistance et un premier condensateur (C1),
le second circuit incluant un second condensateur (C2) et un commutateur (Q1) positionné entre le second condensateur (C2) et une masse, le commutateur et le second condensateur connectés en série étant connectés en parallèle avec le premier condensateur ;
dans lequel le second condensateur (C2) et le commutateur (Q1) sont connectés au convertisseur analogique-numérique (300) par l'intermédiaire de l'une ou des plusieurs broches d'entrée/sortie ;
dans lequel le convertisseur analogique-numérique (300) comprend en outre un contrôleur (310),
**caractérisé en ce que** le contrôleur (310) est configuré pour :
déterminer une fréquence de coupure en fonction du bruit de fréquence d'un environnement dans lequel le dispositif de gestion de batterie est situé, et
déterminer s'il faut activer le second circuit, en activant le commutateur (Q1), en fonction de la fréquence de coupure déterminée, de sorte qu'une fréquence de coupure de bruit générée par le premier circuit et le second circuit soit ajustée.

2. L'appareil de gestion de batterie selon la revendication 1, dans lequel une première fréquence de coupure de bruit générée par le premier circuit diffère d'une seconde fréquence de coupure de bruit générée par le premier circuit et le second circuit.

3. L'appareil de gestion de batterie selon la revendication 1, dans lequel l'une ou les plusieurs broches d'entrée/sortie incluent :
une première entrée/sortie à usage général, GPIO, pour connecter le convertisseur analogique-numérique et le second condensateur ; et
une seconde GPIO pour connecter le convertisseur analogique-numérique et le commutateur.

4. L'appareil de gestion de batterie selon la revendication 3, dans lequel un premier élément de résistance parmi l'au moins un élément de résistance du premier circuit et le premier condensateur sont connectés au convertisseur analogique-numérique par l'intermédiaire de la première GPIO.

5. L'appareil de gestion de batterie selon la revendication 1, dans lequel le contrôleur (310) est configuré pour transmettre un signal d'activation ou un signal de désactivation pour le second circuit au commutateur (Q1) du second circuit par l'intermédiaire de la seconde GPIO.

6. L'appareil de gestion de batterie selon la revendication 1, dans lequel le convertisseur analogique-numérique (300) est inclus dans une unité de microcontrôleur, MCU, ou dans une puce intégrée de surveillance de batterie, BMIC.

7. L'appareil de gestion de batterie selon la revendication 1, dans lequel le commutateur (Q1) est un transistor à effet de champ, FET, ou un transistor à jonction bipolaire, BJT.
